# EUROPEAN PATENT APPLICATION

(11) **EP 4 250 357 A1**
(43) Date of publication of application: **27.09.2023**
(21) Application number: 22195790.5
(22) Date of filing: 15.09.2022
(51) Int. Cl.: H01L 25/16, H01L 25/075, H01L 33/00, G09G 3/20

(54) **A POLYCHROME WAFER STRUCTURE, A POLYCHROME DISPLAY DEVICE, AND A METHOD FOR PRODUCTION**

(30) Priority: 24.03.2022 EP 22164112
(71) Applicant: Micledi Microdisplays BV, 3000 Leuven (BE)
(72) Inventor: VERTOMMEN, Johan, 3220 Holsbeek (BE); STEUDEL, Soeren, 3020 Herent (BE)
(74) Representative: Körfer, Thomas

(57) **Abstract**

A polychrome wafer structure (100,200,200") comprising a plurality of structured first epitaxial dies (102) having first light-emitting devices (107) configured to emit light of a first color, at least a plurality of structured second epitaxial dies (103) having second light-emitting devices (107') configured to emit light of a second color. The plurality of the structured first epitaxial dies (102) and the plurality of the structured second epitaxial dies (103) are bonded on a target wafer (507) with a plurality of common monolithic integrated circuits in a manner that the at least one first die and the at least one second die is connected to one common monolithic integrated circuit (101) for simultaneously driving at least one first epitxial die (102) having light-emitting device (107) and at least one second epitaxial die (103) having light-emitting device (107') by the respective one common monolithic integrated circuit (101).

## Description

The present invention relates to an application that requires devices made from a compound semiconductor. Preferably they are tightly co-integrated with CMOS logic, whereby a plurality of different colors emitting pixel arrays are provided on a single CMOS logic. The application also relates to the method for wafer-to-wafer fabrication of the plurality of different color emitting pixel arrays on the CMOS logic wafer. The wafer-to-wafer fabrication is with respect to silicon LED wafer holding compound semiconductor dies with different color emitting pixel arrays and with respect to a CMOS logic wafer.

Micro-LED (Micro light-emitting diode) displays are one of the enabling technologies for near-to-eye micro-LED displays applied to augmented reality, virtual reality, and mixed reality devices, which require high brightness and high resolution in small screen size. Many portable devices, such as smartphones, portable multimedia players that display high-resolution images also use micro-LED displays. For such applications, the micro-LED displays require a resolution of greater than 1000 pixels per inch and a pixel size lower than 10 microns.

US 2016/0133803 A1 discloses wavelength converted light emitting devices. A method of attaching a plurality of light-emitting devices to a substrate and the wavelength converting material is conformally coating each light emitting device. The drawback of this method is coating dependency and leakage of unconverted light through any portion that lacks the coating fully or partially, hence affecting the final spectrum of the light.

Applicant's earlier non pre-published applications EP 20 214 042.2 filed on December 15, 2020 and US 17/550,508 filed on December 14, 2021, which are incorporated for reference, discloses a method to produce dies for wafer reconstitution. This method improves the wafer yield by identifying the defects in the epitaxial wafer by inspecting the epitaxial wafer and applying an optimized dicing of the epitaxial with the use of an optimized dicing scheme and selecting only good dies for transfer to the LED wafer. The epitaxial wafer in the present invention refers to a wafer of semiconducting material made by epitaxial growth comprising epitaxial layers/films. The substrate of the epitaxial wafer may be silicon, germanium, sapphire, GaAs, or any substrate type used in the industry. This method discloses a die-to-wafer transfer of each good epitaxial die to a dedicated target wafer and later to a dedicated driving CMOS die. The disclosure is especially incorporated for reference to the disclosure of the dicing scheme.

Accordingly, an object of the present invention is to provide a polychrome wafer structure, a polychrome optical display device using the polychrome wafer structure, and a method for producing a polychrome optical display device addressing the aforementioned limitations.

This object is solved by the features of the first independent claim for a polychrome wafer structure, the features of the second independent claim for a polychrome display device, and the features of the third independent claim for the method. The dependent claims contain further developments.

According to a first aspect of the present invention, a polychrome wafer structure is provided. The polychrome optical device comprises a plurality of structured first epitaxial dies having first light-emitting devices configured to emit light of a first color and at least a plurality of structured second epitaxial dies having second light-emitting devices configured to emit light of a second color. The plurality of the structured first epitaxial dies and the plurality of the structured second epitaxial dies are bonded on a target wafer with a plurality of common monolithic integrated circuits in a manner that the at least one first die and the at least one second die are connected to one common monolithic integrated circuit for simultaneously driving at least one first epitaxial die having light-emitting device and at least one second epitaxial die having light-emitting device by the respective one common monolithic integrated circuit. The target wafer may be a CMOS wafer comprising a plurality of ASICs (applicationspecific integrated circuits). The term structured epitaxial dies refer to the epitaxial dies with mesa structures on them.

Therefore, the proposed solution provides a wafer structure comprising at least two co-integrated epitaxial dies each configured to emit a different wavelength or color. In other words, a single AISC will drive two or more light-emitting devices simultaneously. Therefore, the proposed wafer structure minimizes the electrical driving system, reduces the power consumption while providing optimized, and even reduced form factors. The form factor generally relates to the size, shape, and physical specifications of hardware or hardware components.

Preferably, the wafer structure comprises color converter means to convert the light emitted by any of the first light-emitting devices and/or any of the second light-emitting devices to a desired color. The wafer structure comprises the color converter means preferably is a filter, a phosphorous material or a material comprising quantum dots. Therefore, any desired color can be achieved using the wafer structure of the invention. For example, blue light emitted from the first die may be converted into either red, green or any other desired color.

Preferably, the wafer structure further comprises at least a third epitaxial die having third light-emitting devices, one of the third light-emitting devices is configured to emit light of a third color also bonded on each common monolithic integrated circuit of the target wafer. Advantageously, on the same common ASIC besides the first die and the second die, the third die is configured to emit the third color is integrated. For example, the first die may have the first light-emitting devices configured to emit red color, the second die may have the second light-emitting devices configured to emit blue color and the third die may have the third light-emitting devices configured to emit green color. All are bonded onto the same ASIC.

Preferably, the wafer structure further comprises the first epitaxial die having the first light-emitting devices, the second epitaxial die having the second light-emitting devices, and the third epitaxial die having the third light-emitting devices with the same or nearly the same or different epitaxial layer thickness. Advantageously, each of the epitaxial dies may have the same epitaxial layer thickness, thereby allowing fabrication steps to be carried out simultaneously. This may reduce the number of steps involved and cost. Alternatively or additionally, the epitaxial dies may have different epitaxial layer thicknesses. Therefore, epitaxial wafers with different materials and layer compositions can be used to fabricate the wafer structure of the invention. Advantageously, this allows free selection of the epitaxial wafer.

Preferably, the wafer structure further comprises the first epitaxial die having the first light-emitting devices, the second epitaxial die having the second light-emitting devices, and the third epitaxial die having the third light-emitting devices, which are arranged side-by-side to form at least a column and/or row. Therefore, the epitaxial dies having light-emitting devices corresponding to different wavelengths are arranged on each die in a two-dimensional matrix array. Specific arrangements of the pixels on each of the dies depend on arrangement of the epitaxial dies. Advantageously, highdensity pixels and/or tight pixel pitch can be fabricated.

Preferably, the epitaxial dies have the same or different orientations. Different pixel configurations can be achieved by different and/or the same orientation of the epitaxial dies.Advantageously, this is improving the color rending, color fringing artifacts, and resolution of reconstructed images.

Preferably, the wafer structure further comprises several arrays each comprising either a plurality of the first epitaxial dies having the first light-emitting devices or a plurality of the second epitaxial dies having the second light-emitting devices or a plurality of the third epitaxial dies having the third light-emitting devices and one or more arrays are bonded on each common monolithic integrated circuit. Advantageously, this enables achieving color uniformity and/or luminous efficiency over a large area.

Preferably, the color of any of the first light-emitting devices or the second light-emitting devices or the third light-emitting devices selected from red or blue or green, respectively. Any further colors, especially in the wavelength visible to human eyes can be selected for the light-emitting devices, preferably, between 380 nm and 700 nm.

According to a second aspect of the present invention, a polychrome display device has at least one common monolithic integrated circuit with at least one first structured epitaxial die and at least one second structured epitaxial die each diced from the target wafer of the wafer structure of the first aspect of the present invention.

All advantages of the first aspect of the invention are inherent to the second aspect of the invention. In particular, the display device of the present invention could be smaller than the conventional micro-LED display device.

According to a third aspect of the present invention, a method for producing a polychrome optical device is provided. The method has the steps of a) selecting a first epitaxial wafer configured to emit light of a first color, b) producing first dies from the first epitaxial wafer, c) repeating the steps a) and b) at least on a second epitaxial wafer to produce second dies configured to emit light of a second color, d) transferring a plurality of the first dies and a plurality of the second dies onto a transfer wafer, e) structuring the plurality of first dies and the plurality of second dies to form first light-emitting devices and second light-emitting devices, respectively, and f) bonding the transfer wafer with the structured dies to a target wafer with a plurality of common monolithic integrated circuits, such that the light emitting devices each contact the common monolithic integrated circuit, thereby forming the polychrome optical devices in a manner that at least one first die and at least one second die are connected to one common monolithic integrated circuit of the target wafer. In the present invention, the transfer wafer refers to a blank semiconductor wafer used for the purpose of transferring the epitaxial dies to the target wafer. The target wafer is a semiconductor wafer with a plurality of integrated circuits such as ASIC.

The proposed method enables the realization of the wafer structure of the first aspect and the device of the second aspect of the present invention. Advantageously, the method provides transfer technology with at least two colors micro-LED onto a single common monolithic integrated circuit. The proposed method particularly reduces the cost and complexity of producing polychrome wafer structures and enables fabrication of micro LED structures with pixels below 10 µm.

Preferably, the method further comprises the steps of repeating the steps a) to b) at least on a third epitaxial wafer having an epitaxial layer to produce third dies configured to emit light of a third color, transferring a plurality of the third dies on the same transfer wafer, performing step e) for the plurality of third dies, and repeating step f) for the plurality of third dies. For example, the epitaxial dies having light-emitting devices for each color (RGB) are provided on the transfer wafer. The transfer wafer is bonded to a common monolithic integrated circuit such that the light-emitting devices corresponding to three different colors are connected to one common monolithic integrated circuit of the target wafer. Therefore, a single driving circuit chip can drive all the light-emitting devices of the three different colors.

Preferably, the method further comprises the step of aligning, placing, and structuring the first dies, the second dies, and the third dies with respect to alignment markers provided on the transfer wafer and/or target wafer by lithography techniques, preferably by a lithography stepper or scanner. Advantageously, this method offers a very high alignment accuracy. Therefore, the relative position of the dies is always the same.

Preferably, the method further comprises the step of structuring the plurality of dies in step e) by semiconductor processing techniques such as lithography, plasma etching, wet etching and cleaning, chemical mechanical planarization, various deposition techniques (PVD, CVD, ALD, electroplating), griding. For example, mesas are formed by dry etching the epitaxial layer of the epitaxial dies. Processing steps involved in the productions can be performed simultaneously on dies for different colors. Advantageously, this reduces time and cost of production. Alternatively, any of these methods can be performed sequentially.

Preferably, the method further comprises the step of removing a substrate of the transfer wafer and/or substrates of epitaxial dies after bonding step f), preferably by grinding, etching, and/or planarization. The transfer wafer is etched to expose light-emitting devices of different colors simultaneously or sequentially. Advantageously, reducing the time and cost of production.

Preferably, the method has the substrate of the first epitaxial wafers selected from silicon, germanium, GaAs, or sapphire, and/or the transfer wafer is a silicon wafer or a glass wafer. Advantageously, the method allows the use of different wafer materials for red, blue, and green colors.

Preferably, the epitaxial die is cut out of an epitaxial wafer. The epitaxial layer on the first epitaxial wafer and the second epitaxial wafer can be created from a first group of III-V compound, especially GaN, and the epitaxial layer on the third epitaxial wafer can be created from a second group of III-V compound, especially AlInGaP. The emission wavelength is dependent on the composition of the epitaxial layer on the wafer. This method advantageously offers high flexibility in the selection of the epitaxial wafer. Advantageously, the method allows a wide choice of the epitaxial wafer without being restricted by the wafer size, substrate material, epitaxial layer thickness, and availability criteria.

Preferably, the method to produce first dies or second dies or third dies comprises inspecting a first epitaxial wafer to detect one or more defects, a) overlaying a dicing scheme on the first epitaxial wafer with the detected defects, b) identifying the good first dies on the first epitaxial wafer, c) dicing the first wafer and selecting the good first dies on the first epitaxial wafer to produce the first dies, d) selecting a second epitaxial wafer and repeating steps a) to d) to produce the second dies, and f) selecting a third epitaxial wafer and repeating steps a) to d) to produce the third dies. Advantageously, the method allows maximized wafer yield. This method detects good dies and bad dies at the wafer level thereby improving the yield, production capacity, and cost.

The first aspect, the second aspect, and the third aspect achieve the same advantages and effects.

Exemplary embodiments of the invention are now further explained with respect to the drawings by way of example only, and not for limitation. In the drawings:
- Fig. 1A: shows an exemplary schematic representation of a polychrome wafer structure according to the first aspect of the present invention;
- Fig. 1B: shows an exemplary schematic representation of an epitaxial die comprising a plurality of light-emitting devices;
- Fig. 1C-D: show exemplary embodiments of two or more epitaxial dies arranged on an underlying monolithic integrated circuit ;
- Fig. 2A-E: show exemplary embodiments of the wafer structure of the first aspect of the present invention;
- Fig. 3A: shows a conventional RGB display device consisting of the three separate monochrome displays, each driven by their respective ASIC;
- Fig. 3B-C: show exemplary embodiments of a polychrome optical display device integrated into a display system according to the second aspect of the invention,
- Fig. 4: shows an exemplary flowchart of the steps of the method for producing the polychrome optical device according to the third aspect of the invention;
- Fig. 5A-B: show exemplary process process diagrams of the method for producing a polychrome optical device;
- Fig. 5C: shows an exemplary process flow of dicing to package device of Fig. 5A-B;
- Fig. 6A: shows a conventional method for producing the monochrome wafer stcuture; and
- Fig. 6B: shows an exemplary embodiment of the method for producing the polychrome wafer structure according to the invention.

Reference will now be made in detail to the embodiments of the present invention, examples of which are illustrated in the accompanying drawings. However, the following embodiments of the present invention may be variously modified and the range of the present invention is not limited by the following embodiments. Reference signs for similar entities in different embodiments are partially omitted.

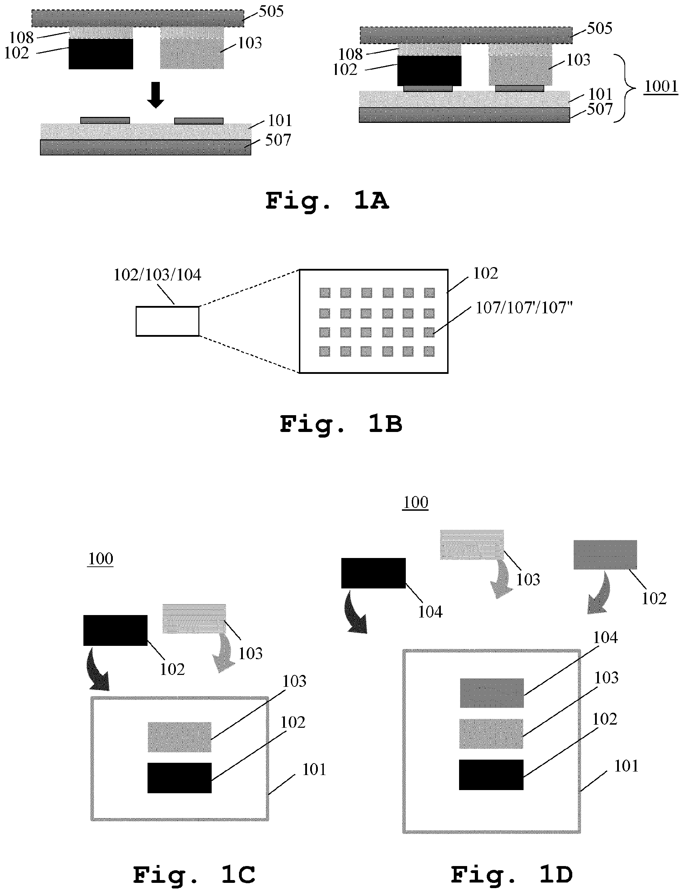

In Fig. 1A, an exemplary schematic representation of a polychrome wafer structure 1001 according to the first aspect of the present invention is illustrated. A first epitaxial die 102 having a plurality of light emitting devices and a second epitaxial die 102 having a plurality of light emitting devices on a transfer wafer 505 are shown. The first epitaxial die 102 and the second epitaxial die 103 are shown with their respective substrates 108. The transfer wafer 505 is flip-chip bonded to a target wafer 507. The target wafer 507 comprises a plurality of common monolithic integrated circuits. The transfer wafer 507 and substrate 108 of the epitaxial dies 102,103 are represented by dashed lines. The polychrome wafer structure 1001 is obtained after appropriately removing the transfer wafer 505 and the substrates 108 of the epitaxial dies 102, 103.

In Fig. 1B, an exemplary schematic representation of the epitaxial die 102,103,104 comprising a plurality of light-emitting devices 107,107',107" is shown. Fig. 1B is only an exemplary representation.

In Fig. 1C, an exemplary embodiment of schemtic of two epitaxial dies arranged relative to the underlying monochromatic integrated circuit according to the first aspect of the present invention is illustrated. A polychrome wafer structure 1001 comprises at least two epitaxial dies 102, 103 each having light-emitting devices 107, 107' configured to emit a first color and a second color, respectively. The first epitaxial die 102 having first light-emitting device 107 and the second epitaxial die 103 having second light-emitting device 107' are bonded on a common monolithic integrated circuit 101. The light emitting devices 107, 107' may comprise a plurality of Micro-LEDs, which can be used for a display. The common monolithic integrated circuit drives the at least two light-emitting devices 107, 107' simultaneously. For example, the first color is red and the second color is blue.

Fig. 1D shows another implementation of the first aspect of the invention. A schematic of three epitaxial dies 102,103,104 arranged relative to the underlying monochromatic integrated circuit. Each of the epitaxial dies 102,103,104 are configured to emit a first color, a second color, and a third color, respectively. The three epitaxial dies 102, 103, 104 each having a plurality of light emitting devices 107,107',107" are bonded on a common monolithic integrated circuit 101. For example, the first color is red, the second color is blue and the third color is green. The three epitaxial dies 102, 103, 104 having their respective light emitting devices are configured to emit images with respective colors, i.e., red, green and blue.

The two or more epitaxial dies 102, 103, 104 emit images with respective colors, i.e. red and blue, which are collimated with a lens. The collimated beam traverse through a waveguide system for example with localized grating portions acting as in and out coupler for the beams (not shown). Preferably, either the first color or the second color is at least partially converted into a third color to provide a third color image. Preferably, a first grating portion is configured (not shown) to couple-in light of the first color, the light of the second color and the light of the third color to the optical waveguide system and a second grating portion is configured to couple-out the light for the first color, the light of the second color and the light of the first color from the optical waveguide system. Whereby each separate waveguide comprises a first grating portion and a second grating portion to couple-in and couple-out the respective light. This allows for an effective beam combination that can be realized on augmented or virtual reality glasses.

Figs. 1A and 1B show the different epitaxial dies 102, 103, 104 that are bonded on the common monolithic integrated circuit 101 and that have a columnar arrangement in this embodiment.

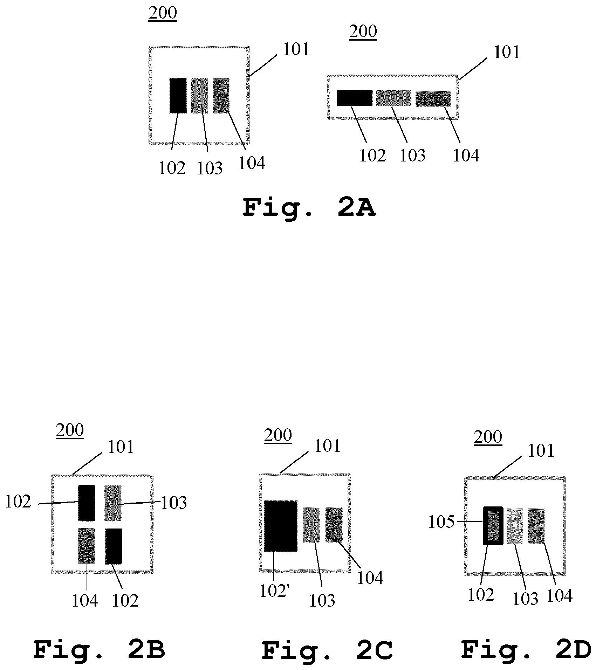

Fig. 2A shows two different implementations of the polychrome wafer structure 200. The epitaxial dies 102, 103, 104 having light emitting devices 107,107',107" are arranged side-by-side to form a row. Fig. 1A-1B and Fig. 2A show the two or three different epitaxial dies 102, 103, 104 having the same size. Alternatively, these implementations can also be realized with the epitaxial dies 102, 103, 104 having different sizes.

Fig. 2B-D show further implementations of the first aspect of the present invention. Fig. 2B shows four epitaxial dies 102, 103, 104, 102 arranged in a 2 x 2 pattern and are bonded on the common monolithic integrated circuit 101. For example, two epitaxial dies 102 configured to emit red , one epitaxial die 103 configured to emit green and one epitaxial die 104 configured to emit blue are shown in Fig. 2B. This implementation may be used to further improve color gamut or contrast. This example shows all four light-emitting devices having equal sizes. A further implementation using epitaxial dies of different sizes arranged in the 2 x 2 matrix pattern is possible.

Another implementation of the first aspect is shown in Fig. 2C, having three epitaxial dies 102', 103, 104. Each epitaxial die may comprise a full matrix of Micro-LEDs. One of the epitaxial dies 102' is larger than other epitaxial dies 103, 104. The epitaxial dies 102', 103, 104 are provided on the common monolithic integrated circuit 101. For example, the epitaxial dies 102' configured to emit red is larger than other epitaxial dies 103, 104. The epitaxial die 102' configured to emit red comprises a plurality of red LEDs. This might be useful for applications that require emphasis on a particular color light.

A still further implementation of the first aspect of the present invention is shown in Fig. 2D. A row of three different epitaxial dies 102, 103, 104 is bonded on the common monolithic integrated circuit 101. A color converter 105 is coupled partially or fully to the first epitaxial die 102. The color converter 105 converts at least a part of the light emitted by the first epitaxial die 102 to the second color, the third color, or any desired color. The color converter 105 may be used in combination with any of the epitaxial dies 102, 103, 104. Said color converter may be color conversion material, color filters, etc.

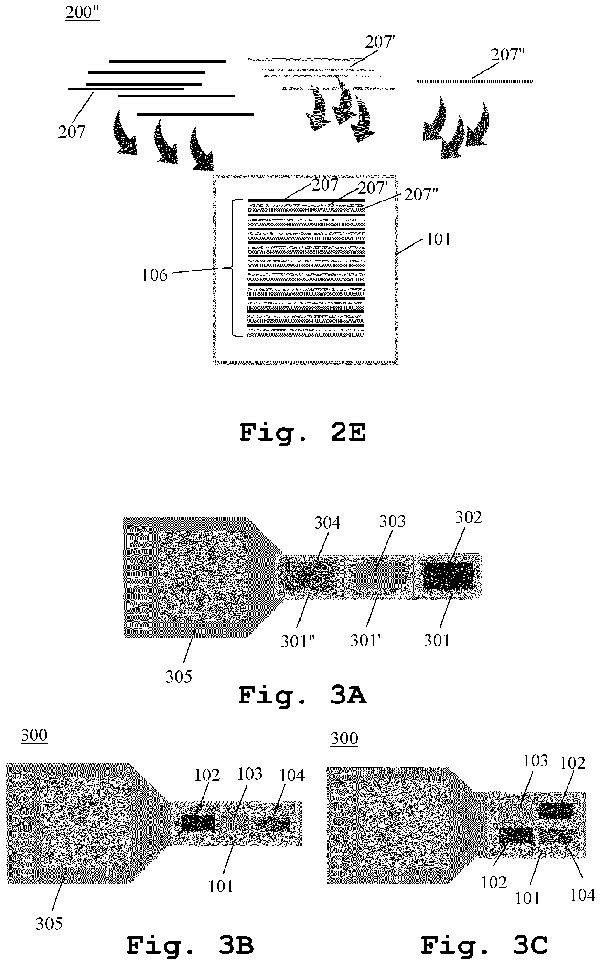

Fig. 2E shows still another implementation of the first aspect of the present invention. A first monochrome one-dimensional array 207 comprises a plurality of first epitaxial dies 102. Similarly, a second monochrome one-dimensional array 207' comprises a plurality of the second epitaxial dies 103 and a third monochrome one-dimensional array 207" comprises a plurality of the third epitaxial dies 104. Each one-dimensional array is formed by a side-by-side arrangement of the plurality of epitaxial dies 102,103,104. Several such one-dimensional arrays 207, 207', 207" are arranged in rows forming repeated RGB patterns as shown in Fig. 2E. All one-dimensional RBG arrays 207, 207', 207" are bonded on the common monolithic integrated circuit 101. The common monolithic circuit 101 may simultaneously drive the plurality of monochrome rows 106, thereby forming a full-color display device. This implementation is also possible with one-dimensional arrays arranged in a columnar arrangement.

A plurality of the first epitaxial dies 207, 207', 207" forms an individual pixel element of the display for any of the above-discussed implementations of the first aspect. Alternatively, this is also true for the second epitaxial dies 103, or the third epitaxial dies 104, and any combinations thereof.

In Fig. 3A, a conventional display system is illustrated. The conventional display system comprises one monochrome epitaxial die having light emitting devices for each color. Each epitaxial die 302, 303, 304 configured to emit different colors is bonded to a dedicated integrated circuit 301, 301', 301", respectively. Each epitaxial die is operated independently of each other by their dedicated driving circuit. The relative position of the epitaxial dies 302,303,304 are limited to the microscopic alignment accuracy of the dies on such a display system. Further, this display system has separate driving elements 301, 301', 301" for each color, making them larger.

In Fig. 3B-C, exemplary embodiments of the polychrome display device integrated into a display system 300 according to the second aspect of the present invention are illustrated. In Fig 3B, a row of three epitaxial dies 102, 103, 104 bonded on the common monolithic integrated circuit 101 according to the invention is shown. Preferably, a connecting means 305 is provided to integrate the display device of the invention to any device such as AR/VR glasses, wearable watches, microprojectors, ultra HD television, etc. Each epitaxial die 102, 103, 104 emits images with respective colors, i.e. red, green, and blue, and are collimated with a lens. The collimated beams traverse through the waveguide system with localized grating portions acting as in and out couplers for the beams.

Using at least two epitaxial dies 102, 103 meet the requirements of the invention. Therefore, the display system 300 shown in Fig. 3B can be realized with any two of the three epitaxial dies 102, 103, 104 bonded on the common monolithic integrated circuit.

A further implementation of the second aspect is shown in Fig. 3C with a 2 x 2 arrangement of four epitaxial dies 102, 103, 104, 102. These epitaxial dies 102, 103, 104, 102 are provided on the common monolithic integrated circuit 101. The common monolithic integrated circuit drives all the light emitting devices simultaneously.

The display system 300 of the invention has higher accuracy because the light emitting devices are arranged by the lithography process. Further, by using the common monolithic integrated circuit to drive all the different epitaxial dies 102, 103, 104, the display system 300 of the invention is smaller and consumes less power than the conventional display system shown in Fig. 3A.

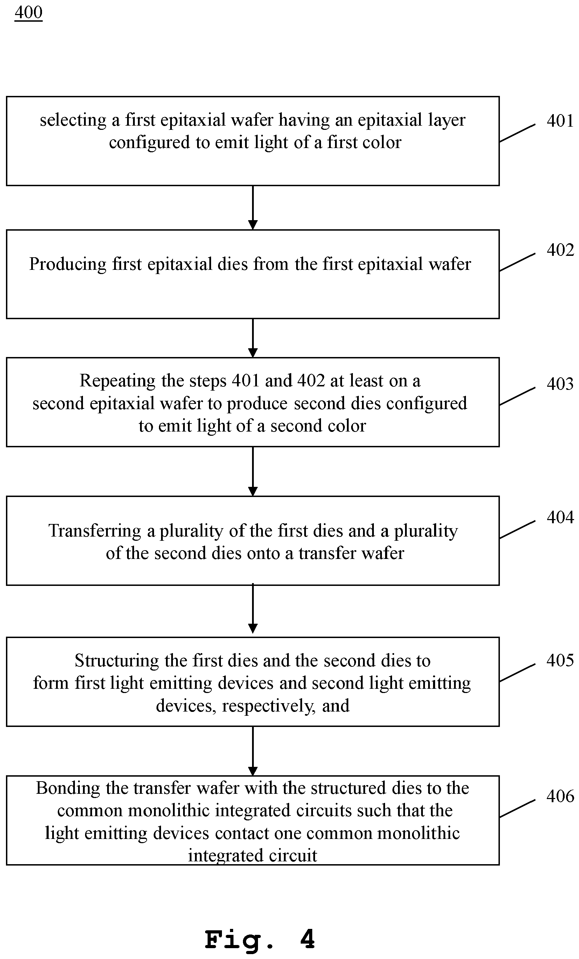

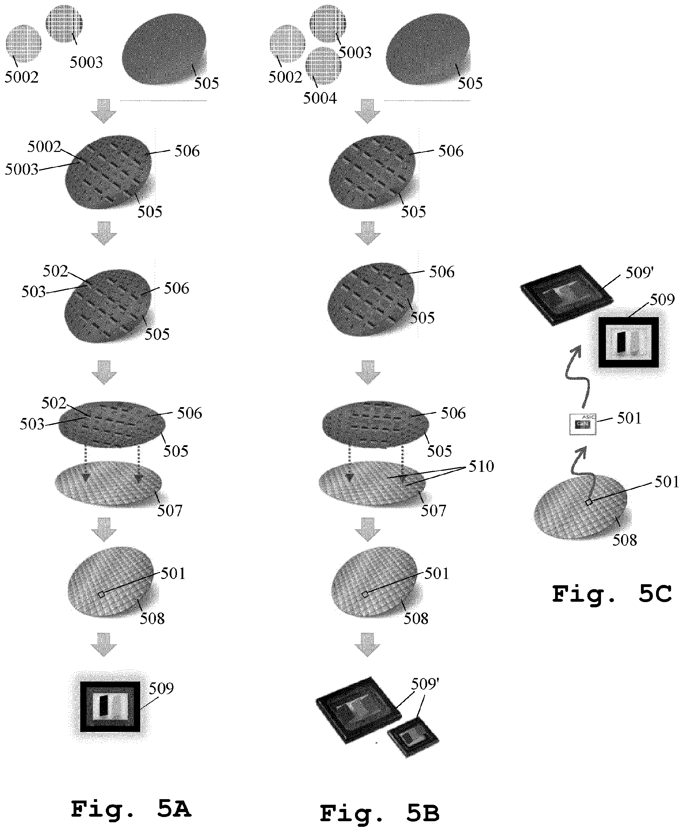

Fig. 4 illustrates an exemplary embodiment of method 400 according to the third aspect of the present invention. In a first step 401, a first epitaxial wafer having an epitaxial layer configured to emit light of a first color is selected. In a second step 402, first dies from the first epitaxial wafer are produced. In a third step 403, at least on a second epitaxial wafer, the steps 401 and 402 are repeated to produce second dies that are configured to emit light of a second color. In a fourth step 404, a plurality of the first dies and a plurality of the second dies are transferred onto a transfer wafer. In the fifth step 405, the first dies and the second dies are structured to form the first light-emitting devices and second light-emitting devices, respectively. In the final step 406, the transfer wafer with the structured dies 102, 103 is bonded to the common monolithic integrated circuits 101 such that the light emitting devices contact one common monolithic integrated circuit. The transfer wafer comprises a plurality of common monolithic integrated circuits. The bonding of the light emitting devices is in a manner that at least two epitaxial dies 102,103 configured to emit light of two different colors are bonded on the common monolithic integrated circuit 101. Detailed discussions about each step are provided with respect to Fig. 5A-C.

In Fig. 5A-B, exemplary embodiments of the process flow diagrams for producing a polychrome optical device according to the third aspect of the present invention are illustrated.

Fig. 5A shows the method steps involved for producing a polychrome optical display device 300 comprising two different epitaxial dies configured to emit two different wavelengths, respectively.

The epitaxial LED material of the die is generally known to include a first doped layer, a second doped layer, and an active or emission layer in-between the first and the second doped layers. The first and second doped layers may be pGaN doped with acceptors or nGaN doped with donators, respectively. An active or emission layer may be MQWs (multi-quantum wells). The substrate material of the epitaxial wafer might be silicon, GaAs, germanium, or sapphire. Further, an ITO layer and several dielectric films are provided on the substrate. Usually, epitaxial wafers of approximately 150-200 mm are used.

In Fig. 5A, the first epitaxial wafer having an epitaxial layer configured to emit light of a first color is selected. The first epitaxial wafer is diced to produce a plurality of first epitaxial dies 5002. In order to improve the yield of the wafers, further steps may be involved to select good dies (discussed below). Similarly, the second epitaxial wafer is selected for emitting a second color and a plurality of second dies 5003 are produced. For example, the first color is red and the second color is green.

The plurality of first dies and the plurality of second dies are transferred onto a transfer wafer 505. The transfer wafer 505 is preferably a silicon wafer or glass of for example about 300 mm. Alignment markers 506 are preferably provided on the transfer wafer 505 in order to accurately align and place the first and the second dies 5002, 5003. Any number and/or combinations of the first dies 5002 and the second dies 5003 can be realized such as RG, RGG, RRG, RGRG, etc. on the transfer wafer 505 with very high accuracy.

In Fig. 5A the RG combination is illustrated. All further processing steps may be carried out on the first dies 5002 and the second dies 5003 simultaneously or sequentially. Planarization of the plurality of first and the second dies 5002, 5003 may be required in order to optimize these dies. The first dies 5002 and the second dies 5003 on the transfer wafer 505 are structured to form the first light-emitting devices and the second light-emitting devices. The alignment markers 506 on the transfer wafer 505 are used for accurately align and/or structure the first dies 5002 and the second dies 5003, for example by a lithography technique, in particular stepper or scanner lithography. The stepper lithography can rapidly repeat or step a pattern across the transfer wafer 505. The lithograph process allows high alignment accuracy of the dies. Other LED processing steps such as etching, dielectric deposition, chemical mechanical planarization, etc. may be carried out too.

Finally, the transfer wafer 505 comprises a plurality of epitaxial dies 502, 503. This transfer wafer is flip-chip bonded, particularly by hybrid bonding, to target wafer 507. The target wafer 507, in particular, is a CMOS IC comprising a plurality of ASICs. The transfer wafer 506 is bonded to the target wafer 507 in a manner that the first light-emitting devices of the first epitaxial die 502 and the second light-emitting devices of the second epitaxial dies 503 are connected to one common monolithic integrated circuit e.g. an ASIC. A plurality of polychrome light-emitting devices is obtained by bonding the transfer wafer 505 on the CMOS wafer 507. The transfer wafer 505 and the substrate of the epitaxial dies are removed by a suitable method such as grinding, etching, wet etching and cleaning, and/or CMP to expose a plurality of the first light-emitting devices and a plurality of the second light-emitting devices. The wafer 508 is diced to obtain a plurality of polychrome optical display devices 501. The resulting polychrome optical device 509 comprises the first light emitting devices and the second light emitting devices.

Fig. 5B shows another implementation of the method for producing a polychrome optical display device having three different colors. All method steps in Fig. 5B correspond to Fig. 5A. Besides the first dies 5002 and the second dies 5003 of Fig. 5A, third dies 5004 is provided in Fig. 5B. Thereby, the resulting polychrome optical display device 509' comprises the first light emitting devices, the second light emitting devices, and the third light emitting devices. These light emitting devices are each contacted on the one common monolithic integrated circuit 510.

Fig. 5C shows the dicing and packaging of the wafer 508. The wafer 508 comprises a plurality of ASIC contacted to the first light emitting device and the second light emitting device. Each polychrome optical device 501 is then packaged 509 for the display devices. Each ASIC has at least two different light emitting devices bonded to it. Each of these light emitting devices may comprise a full matric of LEDs of the corresponding color.

Additional steps may be involved in order to improve the yield of the wafer. The first epitaxial wafer is inspected to detect one or more defects. An optimized dicing scheme is laid on the first epitaxial wafer with detected defects. The dicing scheme may completely or partially avoid the detected defects. Alternatively or additionally, the dicing scheme may allow the detected defects to be present on the edges of the first dies. Thereby, a maximum number of good dies can be selected on the first epitaxial dies. The good dies are diced and used in the method of the third aspect of the present invention. These steps may be repeated on the second epitaxial wafer and/or the third epitaxial wafer. This method allows optimized yield of the wafer. The dicing schemes and selection methods of earlier applications EP 20 214 042.2 and US 17/550,508 are incorporated by reference as mentioned above.

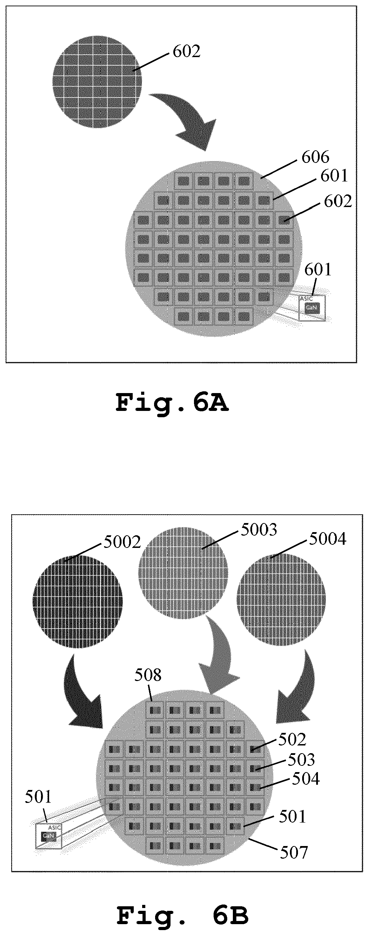

Fig. 6A shows a conventional monochrome wafer 511. All incoming epitaxial dies 602 are configured to emit a single color. The incoming dies 602 are bonded to transfer wafer 601. Thereby, the transfer wafer (not shown here) has a plurality of incoming dies 602. The transfer wafer will be flip-chip bonded to a Si-CMOS wafer 606, which has a plurality of driving elements. Each incoming die 602 is provided with a dedicated driving element 601 for driving it. After further processes to remove the transfer wafer and the substrate of the epitaxial dies, a monochromatic device which emits a first color is formed. Fig. 6A shows a plurality of first epitaxial dies, each having light emitting devices.Each epitaxial die is bonded to its respective driving element. These method steps must be repeated for a second color and a third color with their respective epitaxial dies to produce monochrome devices emitting the second color and the third color, respectively. Therefore, LED chips for each fundamental color (RGB) are produced and integrated for a full-color display. However, if the LED chips are less than 10 microns, it becomes challenging to obtain high-resolution displays. Further, this method results in devices with a higher form factor and lower resolution.

In Fig. 6B, an exemplary polychrome optical device produced according to the third aspect of the present invention is illustrated. The incoming first epitaxial dies 5002 having light emitting devices, second epitaxial dies 5003 having light emitting devices, and third epitaxial dies 5004 having light emitting devices are shown. Each epitaxial dies 5002,5003,5004 configured to emit light of three different colors. The method steps of Fig. 4 are performed on these incoming dies 5002, 5003, 5004 to produce a polychrome optical device. The optical device comprising first epitaxial die 502, second epitaxial die 503, and third epitaxial die 504 corresponding to each color bonded on a common monolithic integrated circuit 510 such that the light emitting devices from different epitaxial dies 5002, 5003, 5004 contact one common monolithic integrated circuit. Further processing steps to remove the substrate of the epitaxial dies 502,503,504 and transfer wafer (not shown in Fig. 6B) are performed. This results in three light emitting devices bonded to the common monolithic integrated circuit 510. A plurality of such polychrome optical devices is shown on the target CMOS wafer 507.

This invention proposes an alternative way to reconstitute wafer structures, wherein a single ASIC or common monolithic integrated circuit comprises at least the first epitaxial die configured to emit light of a first color and a second epitaxial die configured to emit light of a second color. This approach can still be combined with the conventional wafer reconstitution to further improve the display device.

It is important to note that the indefinite article "a" or "an" does not exclude a plurality. Moreover, the description with respect to any of the aspects is also relevant with regard to the other aspects of the invention. Although the invention has been illustrated and described with respect to one or more implementations, equivalent alternations and modifications will occur to others skilled in the art upon the reading and understanding of this specification and the annexed drawings. In addition, while a particular feature of the invention may have been disclosed with respect to only one of several implementations, such features of the other implementations may be desired and advantageous for any given or particular application.

## Claims

1. A polychrome wafer structure (1001) comprising
a plurality of structured first epitaxial dies (102) having first light-emitting devices (107) configured to emit light of a first color,
at least a plurality of structured second epitaxial dies (103) having second light-emitting devices (107') configured to emit light of a second color, and
wherein the plurality of the structured first epitaxial dies (102) and the plurality of the structured second epitaxial dies (103) are bonded on a target wafer (507) with a plurality of common monolithic integrated circuits in a manner that the at least one first die (102) and the at least one second die (103) is connected to one common monolithic integrated circuit (101) for simultaneously driving at least one first light-emitting device (107) and at least one second light-emitting device (107') by the respective one common monolithic integrated circuit (101).

2. The wafer structure (1001) according to claim 1,
wherein color converter means (105) are employed to convert the light emitted by any of the first light-emitting devices (107) and/or any of the second light-emitting devices (107') to a desired color,
wherein the color converter means (105) preferably are a filter, a phosphorous material or a material comprising quantum dots.

3. The wafer structure (1001) according to claim 1 or 2, further comprising,
at least a third epitaxial die (104) having third light-emitting devices (107") configured to emit light of a third color,
wherein the third epitaxial die (104) having light-emitting devices (107") is also bonded on the common monolithic integrated circuit (101) of the target wafer (507) .

4. The wafer structure (1001) according to claim 3,
wherein the first epitaxial die (102) having the first light-emitting devices (107), the second epitaxial die (103) having the second light-emitting devices (107') and the third epitaxial die (104) having the third light-emitting devices (107") have the same or nearly the same or different epitaxial layer thicknesses.

5. The wafer structure (1001) according to claim 3 or 4,
wherein the first epitaxial die (102) having the first light-emitting devices (107), the second epitaxial die (103) having the second light-emitting devices (107') and the third epitaxial die (103) having the third light-emitting devices (107") are arranged side by side to form columns and/or rows.

6. The wafer structure (1001) according to any one of claims 3 to 5,
wherein each of the first epitaxial die (102) having the first light-emitting devices (107), the second epitaxial die (103) having the second light-emitting devices (107') and the third epitaxial die (104) having the third light-emitting devices (107") bonded on each common monolithic integrated circuit (101) have the same or different sizes.

7. The wafer structure (1001) according to any one of claims 3 to 6,
wherein the first epitaxial die (102) having the first light-emitting devices (107), the second epitaxial die (103) having the second light-emitting devices (107') and the third epitaxial die (104) having the third light-emitting devices (107") have the same or different orientations.

8. The wafer structure (1001) according to any one of claims 3 to 7,
wherein several arrays (106) each comprise either a plurality of the first light-emitting devices (207) of the first epitaxial die or a plurality of the second light-emitting devices (207') of the second epitxail die or a plurality of the third light-emitting devices of the third epitaxial die(207"), and
wherein one or more arrays (106) are bonded on each common monolithic integrated circuit (101).

9. The wafer structure (1001) according to any one of claims 3 to 8,
wherein the color of any of the first light-emitting devices (107,207) or the second light-emitting devices (107',207') or the third light-emitting devices (107",207") is selected from red or blue or green, respectively.

10. The wafer structure (1001) according to any of claims 3 to 9,
wherein a specific number of at least one first light-emitting device (107,207), at least one second light-emitting device (107',207') and at least one third light-emitting device (107",207") form an individual pixel element of a display device.

11. A polychrome display device (300),
having at least one common monolithic integrated circuit (101) with at least one first structured epitaxial die and at least one second structured epitaxial die each diced from the target wafer (507) of the polychrome wafer structure (1001) of one of claims 1 to 10.

12. A method for producing a polychrome optical device comprising:
a) selecting (401) a first epitaxial wafer having an epitaxial layer configured to emit light of a first color,
b) producing (402) first dies (5002) from the first epitaxial wafer,
c) repeating (403) the steps a) and b) at least on a second epitaxial wafer to produce second dies (5003) configured to emit light of a second color,
d) transferring (404) a plurality of the first dies (5002) and a plurality of the second dies (5003) onto a transfer wafer (505),
e) structuring (405) the plurality of first dies (5002) and the plurality of second dies (5003) to form first light-emitting devices (107) and second light-emitting devices (107'), respectively, and
f) bonding the transfer wafer (505) with the structured dies to a target wafer (507) with common monolithic integrated circuits (510) such that the light emitting devices (107,107') each contact one common monolithic integrated circuit (510), thereby forming the polychrome optical devices (501) in a manner that at least one first die (5002) and at least one second die (5003) are connected to one common monolithic integrated circuit (510) of the target wafer (507).

13. The method according to claim 12, further comprising:
repeating the steps a) to b) at least on a third epitaxial wafer having an epitaxial layer to produce third dies (5004) configured to emit light of a third color,
transferring a plurality of the third dies (5004) on the same transfer wafer (505),
performing step e) for the plurality of third dies (5004), and
repeating step f) for the plurality of third dies (5004).

14. The method according to claim 13, further comprising:
aligning and placing the first dies (5002), the second dies (5003), and the third dies (5004) with respect to alignment markers (506) provided on the transfer wafer (505) and/or target wafer (507) by lithography techniques, preferably by a lithography stepper or scanner.

15. The method according to any one of the claims 12 to 14, further comprising:
structuring the plurality of dies (5002, 5003, 5004) in step e) by semiconductor processing techniques such as lithography, plasma etching, wet etching and cleaning,chemical mechanical planarization, vapor deposition techniques (PVD, CVD, ALD, electroplating), and/or grinding

16. The method according to any one of the claims 12 to 15, further comprising:
removing the transfer wafer (505) and/or substrates (108) of the epitaxial dies (102,103,104)after bonding step f), preferably by grinding, etching and/or planarization.

17. The method according to any one of claims 12 to 16,
wherein the substrate of the first epitaxial wafers is selected from silicon, germanium, GaAs, or sapphire, and/or
wherein the transfer wafer (505) is a silicon wafer or glass wafer.

18. The method according to claim 13 or 14,
wherein an epitaxial layer on the first epitaxial wafer layer and/or an epitaxial layer the second epitaxial wafer and/or an epitaxial layer on the third epitaxial wafer is a III-V compound, and/or
wherein the epitaxial layer on the first epitaxial wafer and the epitaxial layer on the second epitaxial wafer are created from a first group of III-V compounds, especially GaN, and the epitaxial layer on the third epitaxial wafer is created from a second group of III-V compound, especially AlInGaP.

19. The method according to any one of claims 13, 14 to 18, the steps to produce first dies or second dies or third dies comprising:
a) inspecting the first epitaxial wafer to detect one or more defects,
b) overlaying a dicing scheme on the first epitaxial wafer with the detected defects,
c) selecting areas for good first dies on the first epitaxial wafer,
d) dicing the good first dies on the first epitaxial wafer to produce the first dies (5002), and
e) selecting the second epitaxial wafer and repeating steps a) to d) to produce the second dies (5003), and
f) selecting the third epitaxial wafer and repeating steps a) to d) to produce the third dies (5004).

## Amended claims

### Amended claims in accordance with Rule 137(2) EPC.

1. A polychrome wafer structure (1001) comprising
a plurality of structured first epitaxial dies (102) having first light-emitting devices (107) configured to emit light of a first color,
at least a plurality of structured second epitaxial dies (103) having second light-emitting devices (107') configured to emit light of a second color, and
wherein the plurality of the structured first epitaxial dies (102) and the plurality of the structured second epitaxial dies (103) are bonded on a target wafer (507) with a plurality of common monolithic integrated circuits in a manner that the at least one first die (102) and the at least one second die (103) is connected to one common monolithic integrated circuit (101) for simultaneously driving at least one first light-emitting device (107) and at least one second light-emitting device (107') by the respective one common monolithic integrated circuit (101);
**characterized in that**
a specific number of the first light-emitting devices (107) and of the second light-emitting devices (107') form an individual pixel element of a display device.

2. The wafer structure (1001) according to claim 1,
wherein color converter means (105) are employed to convert the light emitted by any of the first light-emitting devices (107) and/or any of the second light-emitting devices (107') to a desired color,
wherein the color converter means (105) preferably are a filter, a phosphorous material or a material comprising quantum dots.

3. The wafer structure (1001) according to claim 1 or 2, further comprising,
at least a third epitaxial die (104) having third light-emitting devices (107") configured to emit light of a third color,
wherein the third epitaxial die (104) having light-emitting devices (107") is also bonded on the common monolithic integrated circuit (101) of the target wafer (507).

4. The wafer structure (1001) according to claim 3,
wherein the first epitaxial die (102) having the first light-emitting devices (107), the second epitaxial die (103) having the second light-emitting devices (107') and the third epitaxial die (104) having the third light-emitting devices (107") have the same or nearly the same or different epitaxial layer thicknesses.

5. The wafer structure (1001) according to claim 3 or 4,
wherein the first epitaxial die (102) having the first light-emitting devices (107), the second epitaxial die (103) having the second light-emitting devices (107') and the third epitaxial die (103) having the third light-emitting devices (107") are arranged side by side to form columns and/or rows.

6. The wafer structure (1001) according to any one of claims 3 to 5,
wherein each of the first epitaxial die (102) having the first light-emitting devices (107), the second epitaxial die (103) having the second light-emitting devices (107') and the third epitaxial die (104) having the third light-emitting devices (107") bonded on each common monolithic integrated circuit (101) have the same or different sizes.

7. The wafer structure (1001) according to any one of claims 3 to 6,
wherein the first epitaxial die (102) having the first light-emitting devices (107), the second epitaxial die (103) having the second light-emitting devices (107') and the third epitaxial die (104) having the third light-emitting devices (107") have the same or different orientations.

8. The wafer structure (1001) according to any one of claims 3 to 7,
wherein several arrays (106) each comprise either a plurality of the first light-emitting devices (207) of the first epitaxial die or a plurality of the second light-emitting devices (207') of the second epitxail die or a plurality of the third light-emitting devices of the third epitaxial die(207"), and
wherein one or more arrays (106) are bonded on each common monolithic integrated circuit (101).

9. The wafer structure (1001) according to any one of claims 3 to 8,
wherein the color of any of the first light-emitting devices (107,207) or the second light-emitting devices (107',207') or the third light-emitting devices (107",207") is selected from red or blue or green, respectively.

10. The wafer structure (1001) according to any of claims 3 to 9,
wherein a specific number of the at least one first light-emitting device (107,207), the at least one second light-emitting device (107',207') and at least one third light-emitting device (107",207") form an the individual pixel element of the display device.

11. A polychrome display device (300),
having at least one common monolithic integrated circuit (101) with at least one first structured epitaxial die and at least one second structured epitaxial die each diced from the target wafer (507) of the polychrome wafer structure (1001) of one of claims 1 to 10.

12. A method for producing a polychrome optical device comprising:
a) selecting (401) a first epitaxial wafer having an epitaxial layer configured to emit light of a first color,
b) producing (402) first dies (5002) from the first epitaxial wafer,
c) repeating (403) the steps a) and b) at least on a second epitaxial wafer to produce second dies (5003) configured to emit light of a second color,
d) transferring (404) a plurality of the first dies (5002) and a plurality of the second dies (5003) onto a transfer wafer (505),
e) structuring (405) the plurality of first dies (5002) and the plurality of second dies (5003) to form first light-emitting devices (107) and second light-emitting devices (107'), respectively, and
f) bonding the transfer wafer (505) with the structured dies to a target wafer (507) with common monolithic integrated circuits (510) such that the light emitting devices (107,107') each contact one common monolithic integrated circuit (510), thereby forming the polychrome optical devices (501) in a manner that at least one first die (5002) and at least one second die (5003) are connected to one common monolithic integrated circuit (510) of the target wafer (507).

13. The method according to claim 12, further comprising:
repeating the steps a) to b) at least on a third epitaxial wafer having an epitaxial layer to produce third dies (5004) configured to emit light of a third color,
transferring a plurality of the third dies (5004) on the same transfer wafer (505),
performing step e) for the plurality of third dies (5004), and
repeating step f) for the plurality of third dies (5004).

14. The method according to claim 13, further comprising:
aligning and placing the first dies (5002), the second dies (5003), and the third dies (5004) with respect to alignment markers (506) provided on the transfer wafer (505) and/or target wafer (507) by lithography techniques, preferably by a lithography stepper or scanner.

15. The method according to any one of the claims 12 to 14, further comprising:
structuring the plurality of dies (5002, 5003, 5004) in step e) by semiconductor processing techniques such as lithography, plasma etching, wet etching and cleaning,chemical mechanical planarization, vapor deposition techniques (PVD, CVD, ALD, electroplating), and/or grinding

16. The method according to any one of the claims 12 to 15, further comprising:
removing the transfer wafer (505) and/or substrates (108) of the epitaxial dies (102,103,104)after bonding step f), preferably by grinding, etching and/or planarization.

17. The method according to any one of claims 12 to 16,
wherein the substrate of the first epitaxial wafers is selected from silicon, germanium, GaAs, or sapphire, and/or
wherein the transfer wafer (505) is a silicon wafer or glass wafer.

18. The method according to claim 13 or 14,
wherein an epitaxial layer on the first epitaxial wafer layer and/or an epitaxial layer the second epitaxial wafer and/or an epitaxial layer on the third epitaxial wafer is a III-V compound, and/or
wherein the epitaxial layer on the first epitaxial wafer and the epitaxial layer on the second epitaxial wafer are created from a first group of III-V compounds, especially GaN, and the epitaxial layer on the third epitaxial wafer is created from a second group of III-V compound, especially AlInGaP.

19. The method according to any one of claims 13, 14 to 18, the steps to produce first dies or second dies or third dies comprising:
a) inspecting the first epitaxial wafer to detect one or more defects,
b) overlaying a dicing scheme on the first epitaxial wafer with the detected defects,
c) selecting areas for good first dies on the first epitaxial wafer,
d) dicing the good first dies on the first epitaxial wafer to produce the first dies (5002), and
e) selecting the second epitaxial wafer and repeating steps a) to d) to produce the second dies (5003), and
f) selecting the third epitaxial wafer and repeating steps a) to d) to produce the third dies (5004).
